# EUROPEAN PATENT SPECIFICATION

(11) **EP 0 785 573 B1**
(45) Date of publication and mention of the grant of the patent: **14.12.2005**
(21) Application number: 97200810.6
(22) Date of filing: 27.10.1995
(51) Int. Cl.: H01L 21/336, H01L 21/60

(54) **Method of forming raised source/drain regions in an integrated circuit**
Verfahren zur Bildung von erhöhten Source- und Drainzonen in integrierten Schaltungen
Méthode pour former des régions de source/drain saillantes dans un circuit intégré

(30) Priority: 31.10.1994 US 331691
(43) Date of publication of application: 23.07.1997
(62) Divisional of application: 95307656.9
(73) Proprietor: STMicroelectronics, Inc., Carrollton Texas 75006-5039 (US)
(72) Inventor: Chan, Tsiu Chiu, Carrollton, Texas 75006 (US); Smith, Gregory C., Carrollton, Texas 75007 (US)
(74) Representative: Driver, Virginia Rozanne

(56) References cited:
- US-A- 4 713 356
- US-A- 4 737 828
- US-A- 5 156 994
- US-A- 5 182 619
- PATENT ABSTRACTS OF JAPAN vol. 018, no. 340 (E-1569), 27 June 1994 -& JP 06 085259 A (FUJITSU LTD), 25 March 1994,

## Description

The present invention relates generally to semiconductor integrated circuit processing, and more specifically to an improved method of forming planarized transistors by forming raised source and drain regions while reducing junction leakage and preventing shorting conditions.

As is well known in the field of integrated circuit design, layout and fabrication, the manufacturing cost of a given integrated circuit is largely dependent upon the chip area required to implement desired functions. The chip area, in turn, is defined by the geometries and sizes of the active components such as gate electrodes in metal-oxide-semiconductor (MOS) technology, and diffused regions such as MOS source and drain regions and bipolar emitters and base regions. These geometries and sizes are often dependent upon the photolithographic resolution available for the particular manufacturing facility. The goal of photolithography in establishing the horizontal dimensions of the various devices and circuits is to create a pattern which meets design requirements as well as to correctly align the circuit pattern on the surface of the wafer. As line widths shrink smaller and smaller in submicron photolithography, the process to print lines and contact holes in photoresist becomes increasingly more difficult.

With circuit advancement to the ultra-large-scale integration (ULSI) levels, more and more layers are added to the surface of the wafer. These additional layers in turn create more steps on the wafer surface. The resolution of small image sizes in photolithography thus becomes more difficult over the additional steps because it becomes more difficult due to the increased problem of depth of focus. Planarization techniques become increasingly more important to offset the effects of a varied topography.

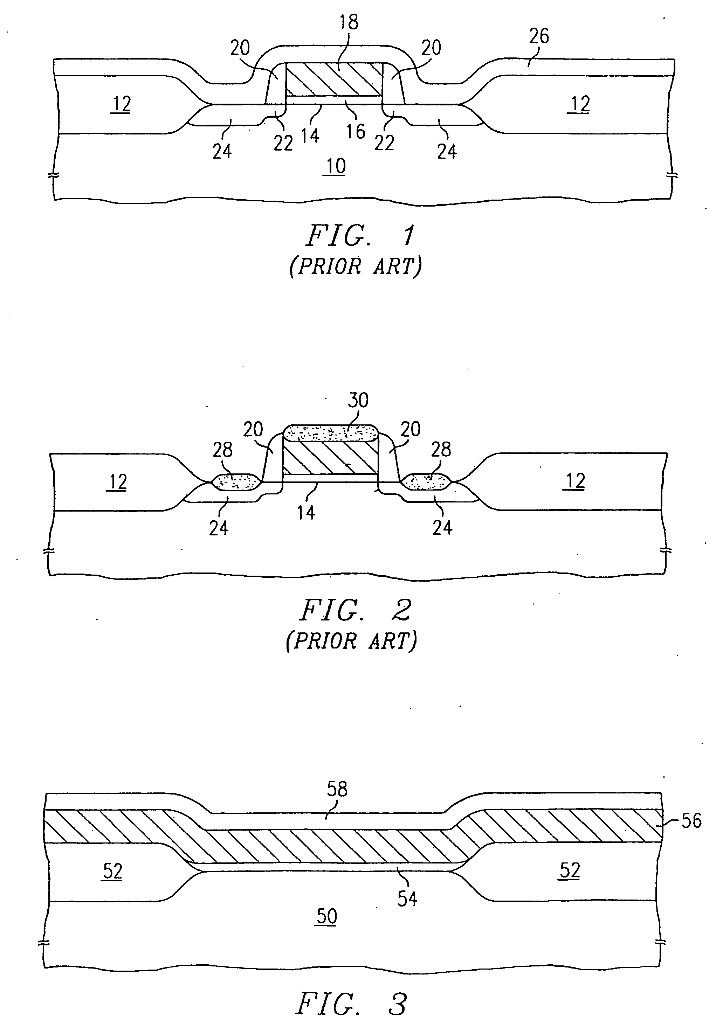

The formation of contact structures as transistor dimensions decrease is also important to predict and control device performance. A variety of contact structures have been considered to alleviate various, problems such as contact resistance and the maximum area of devices available, such as the areas of source and drain regions, in order to make full contact to the devices with the contact structures. Self-aligned silicides are one alternative for alleviating contact area and resistivity problems associated with contacting source and drain regions. In addition, the self-aligned silicides make the diffused regions more conductive and lowers the sheet resistance of the diffused regions. This self-aligned process is shown with reference to Figures 1 and 2. After the transistor 14 is formed having gate oxide 16 and polysilicon or polycide gate electrode 18, the lightly doped drain (LDD) regions 22 are formed by conventional methods by implanting a light dose at the edge of the gate electrode near the channel to overcome such problems as hot-carrier effects. Sidewall oxide spacers 20 are formed along the edge of the gate electrode and gate oxide. The source/drain regions 24 are implanted with a heavier dose to form the source/drain junctions. A metal 26 is deposited over the integrated circuit after which the wafer is heated. The silicon in the source/drain regions 24 then reacts with the metal 26 to form a silicide 28 as shown in Figure 2. This process is called salicide if the silicide over the source/drain regions is formed at the same time as the silicide 30 over the polysilicon gate electrode. Everywhere there is silicon, the metal will react to form a silicide (the source/drain regions in area 28 and the polysilicon in region 30). Elsewhere the metal remains unreacted and is selectively removed. A dielectric layer is typically formed over the integrated circuit with contact openings formed to the source/drain regions and the polysilicon gate. The openings are generally filled with a metal to make contact to the silicide regions 28 and 30.

The refractory metals including titanium, tungsten, tantalum and cobalt have proven well-suited for use as the metal with which to form the silicide since the reaction with silicon occurs at relatively low processing temperatures, for example, 600° C or less. There are, however, disadvantages with this process of silicide formation. First, the silicide formation consumes a portion of the substrate silicon thus reducing the integrity of the source/drain regions. Second, titanium is commonly used for the silicide metal because of its low resistivity. However, during titanium disilicide formation, silicon tends to diffuse into the titanium which then may react over the top of the sidewall oxide spacers. If silicide is formed over the oxide spacers it is continuous between the silicide formed over the polysilicon gate and the source/drain regions which will cause shorting between the gate electrode and the source drain regions.

Reference is made to US 5,182,619 which describes a process in which elevated source and drain electrodes are formed by selective deposition of monocrystalline or polycrystalline silicon. A refractory metal layer is deposited on top of the raised source and drain electrodes and thermally reacted to form silicide regions. This process has the disadvantage that in the deposition of the silicon to form the source and drain raised electrodes, natural growth of the selected deposited silicon can occur, and facets can be formed because monocrystalline material have a crystallographic orientation such that growth or deposition is preferred in only a few directions.

US 5,182,619 deals with the problem of these facets by forming a gate electrode with shelf portions so that facets are formed over the shelf portions and do not interfere with doping of the substrate.

US 5,156,994 also discusses the creation of semiconductor interconnect segments on either side of a gate electrode, the interconnect segments being formed by selective semiconductor growth of undoped or doped semiconductor material. The segments can be subsequently reacted with a refractory metal to provide connections. The difficulties which might occur by the formation of facets in the selective semiconductor growth process is not addressed in US 5,156,994.

US-A-4 713 356 and US-A-4 737 828 disclose processes of the kind.

It is an object of the present invention to provide a method of forming raised source and drain regions with reduced resistivity and in a manner which reduces junction leakage and reduces shorting between the gate and source/drain regions, avoiding the problems with silicon growth.

The invention may be incorporated into a method for forming a semiconductor device structure, and the semiconductor device structure formed thereby. A transistor is formed over a substrate having a gate electrode overlying a gate oxide, wherein the transistor is electrically isolated from other devices by a plurality of field oxide regions. A dielectric capping layer is formed over the gate electrode. LDD regions are formed in the substrate adjacent to the gate electrode. Sidewall oxide spacers are formed adjacent to the transistor. Raised conductive source/drain regions are formed adjacent to the sidewall oxide spacers and overlying the exposed LDD regions. The raised source/drain regions are preferably formed to a height above the substrate which is substantially planar with the height of the transistor above the substrate to aid in the planarization of the wafer before subsequent processing steps occur. There is provided according to the invention a method of forming a semiconductor integrated circuit, comprising the steps of : forming a transistor over a substrate having a gate electrode layer overlying a gate oxide layer, wherein the transistor is electrically isolated by a plurality of field oxide regions, forming a dielectric capping layer on the gate electrode layer; etching a gate electrode from the gate oxide layer, gate electrode layer, and capping layer; forming lightly doped regions in the substrate adjacent to the gate electrode; forming sidewall oxide spacers adjacent to the transistor after the LDD regions are formed; and forming planarized raised source/drain regions adjacent to the sidewall oxide spacers; characterized in that the raised source/drain regions are metal and in that the step of forming a planarized raised metal source/drain regions further comprises the steps of: prior to forming the raised source/drain regions, forming more heavily doped substrate source and drain regions in the substrate after the sidewall oxide spacers are formed; and then forming metal regions over the substrate source and drain regions and wherein said metal source/drain regions overly the substrate source/drain regions formed from said LDD region, leaving a portion of the capping layer and sidewall spacers exposed.

The raised source/drain regions aid in reducing punchthrough in the channel under the transistor.

The capping layer may comprise oxide or nitride.

The formation of the transistor may comprise the steps of forming an oxide layer over the integrated circuit, forming polysilicon over the gate oxide, and patterning and etching the polysilicon and oxide layers to form the gate electrode and gate oxide, respectively. The formation of the transistor may further comprise the step of forming a silicide layer over the polysilicon.

Forming the capping layer may further comprise the step of forming a dielectric layer to a thickness of 1000-3000 angstroms over the polysilicon layer before the polysilicon is patterned and etched to form the transistor. Forming the capping layer may further comprise the step of forming a dielectric layer to a thickness of 1000-3000 angstroms over the silicide layer before the polysilicon and silicide are patterned and etched.

The height of the transistor above the substrate may be 1000-3500 angstroms. The transistor gate electrode may be between .2 to .5 microns wide.

Forming a planarizing raised conductive source/drain region may comprise forming a metal layer over the integrated circuit to a height greater than the capping layer, patterning and etching the metal layer to remain over the transistor and substrate source and drain regions, and removing the metal layer over a portion of the encapsulated transistor, e.g. the capping layer and a portion of the sidewall oxide spacers. The removal of the metal layer may comprise reactive ion etching.

Forming a planarizing raised conductive source/drain region may comprise selectively depositing a metal region over the substrate source and drain regions.

The height of an upper surface of the planarizing raised source/drain regions above the substrate surface may be approximately the same as the height of an upper surface of the gate electrode of the transistor above the substrate surface.

The distance between the planarizing raised conductive source/drain regions and the gate electrode may be large enough for adequate electrical isolation to prevent shorting between the raised source/drain regions and the gate electrode.

The method of forming the transistor may further comprise the steps wherein said planarized raised metal source/drain regions are formed such that an upper surface of the raised second source and drain regions are substantially planar with an upper surface of the gate electrode of the transistor and wherein the second source/drain regions are electrically isolated from the gate electrode layer.

The invention is set forth in the appended claims. The invention as well as a preferred mode of use and further objects and advantages thereof will best be understood by reference to the following detailed description of illustrative embodiments when read in conjunction with the accompanying drawings, wherein:
Figures 1-2 are cross sectional views of the fabrication of a semiconductor integrated circuit according to the prior art.
Figures 3 and 4 are cross sectional views of the first steps in fabrication of a semiconductor integrated circuit.
Figures 5-6 are cross sectional views of the fabrication of a semiconductor integrated circuit according to a first embodiment of the present invention.
Figure 7 is a cross sectional view of the fabrication of a semiconductor integrated circuit according to a second embodiment of the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

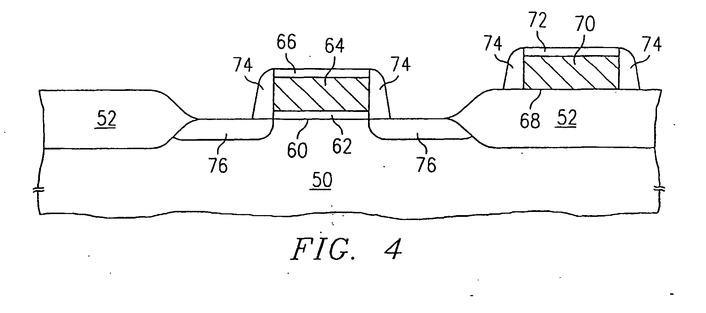

Referring now to Figures 3-4, first steps of a manufacturing process not forming part of the present invention will now be described in detail. Figure 3 illustrates a portion of a wafer, in cross-section, which has a surface at which isolation structures and devices in adjacent active areas are to be formed. As shown in Figure 3, an integrated circuit is to be formed on a silicon substrate 50. The silicon substrate may be p- or n- doped silicon depending upon the location in the wafer where the isolation and active devices are to be formed. Field oxide regions 52 are formed on various portions of the wafer to isolate the active areas where devices will be formed. After various conventional processing steps have been performed if necessary to remove any nitride formed under the field oxide regions, such as a sacrificial oxide layer, a gate oxide layer 54 is thermally grown over the silicon substrate 50 to a depth of approximately 20 to 300 angstroms. A polysilicon layer 56 is formed over the oxide layer 54 and field oxide regions 52 to a depth of between approximately 1000-6000 angstroms. An dielectric capping layer 58 such as oxide or nitride is then formed over the polysilicon layer 56 to a depth of between approximately 1000 to 2000 angstroms.

Referring to Figure 4, the gate oxide 54, polysilicon layer 56 and oxide capping layer 58 are then patterned and etched to form gates of transistors 60 and interconnect lines 68. Transistor 60 comprises gate oxide 62, polysilicon gate electrode 64 and dielectric capping layer 66. Gate electrode 64 may alternatively comprise a silicide of between approximately 1000 to 2000 angstroms overlying the polysilicon layer. The silicide will help to reduce the sheet resistance of the polysilicon gate. Lightly doped drain and source regions 76 are formed, typically with a phosphorous implant in the silicon substrate adjacent to the edge of the gate electrode 64. Sidewall oxide spacers 74 are then formed along the edge of the transistor gate. However, with the capping layer 66 overlying the gate electrode 64, the sidewall spacers 74 will also form along the side of the capping layer 66.

Interconnect 68 is formed over the field oxide region 52 from the same polysilicon layer 56 as that used to form gate electrode 64. After the patterning and etching step, the dielectric capping layer 72 remains over the polysilicon interconnect 70. A silicide may also be formed over the polysilicon underlying the capping layer to reduce the sheet resistance. Sidewall oxide spacers 74 are also formed along the edge of the interconnect 68.

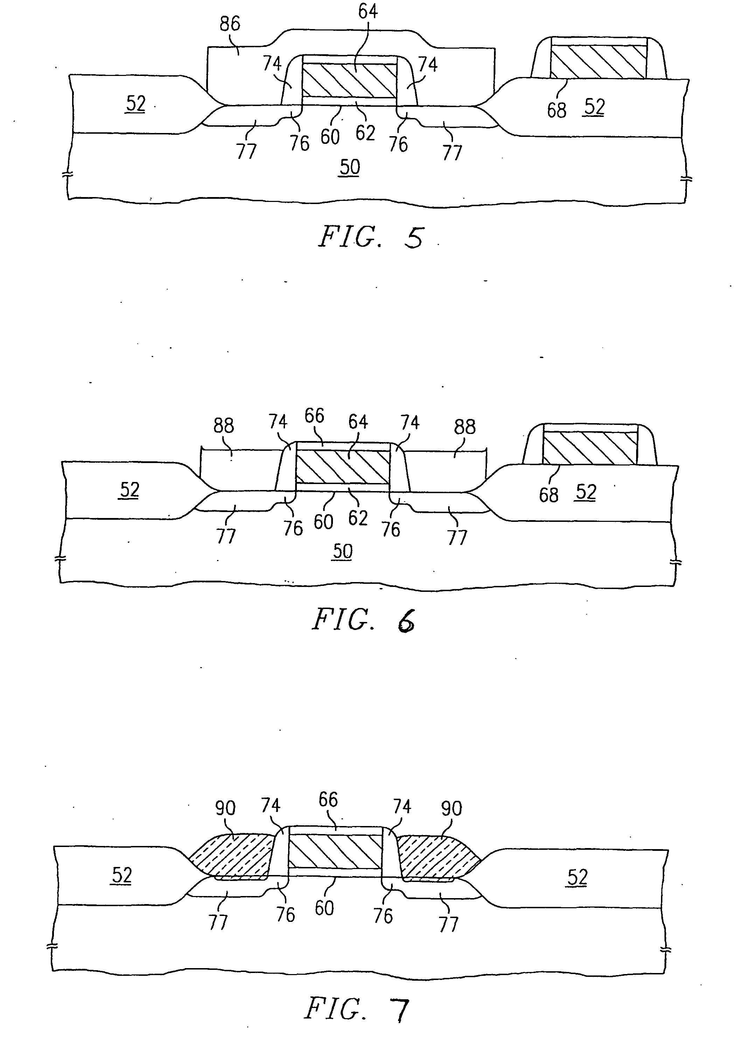

Referring to Figures 5-6, a first alternative embodiment is shown. The same reference numerals are used for similar regions as above with reference to Figures 3-4. In this embodiment, the N⁺ or P⁺ heavily doped source and drain regions 77 are formed by conventional methods after the sidewall oxide spacers are formed and before the raised source/drain regions are formed.

Typically, the more heavily doped source/drain regions have a deeper junction than the LDD regions as shown by the source/drain regions 24 in Figure 1. While the same depth may be achieved in the present invention, alternatively, the source/drain regions 77 may have the same or less junction depth in the deepest portion than the LDD regions already formed.

LDD regions may typically form to a depth of approximately 1000 angstroms. In NMOS devices, the dose required for this depth would normally be approximately 1-4 X 10¹³ atoms/cm² of phosphorous. With a standard source/drain diffusion, as shown in Figure 1, the second more heavily doped source and drain regions junctions are formed to a depth of approximately 1500 angstroms below the silicon surface. In NMOS devices, the implant is typically arsenic at a dose of about 5 X 10¹⁵ atoms/cm². The depth of the source and drain regions can be made deeper than the LDD regions without impacting device performance since the more heavily doped source/drain regions are further away from the channel. Using a normal salicide process as shown in Figure 2, the silicide formation 28 consumes a portion of the source and drain regions 24, approximately 700 angstroms of the 1500 angstroms. If a large enough amount of silicon is consumed, undesired results may be obtained, for example, there may be a low or leaky drain to substrate diode breakdown voltage and the silicide may encroach into the LDD regions effectively reducing the device integrity.

With a shallower source/drain region, the width of the gate, thus the length of the channel "L", may be shortened without adversely affecting device performance. For example, if the standard submicron gate width is .5 microns, this process may allow reduction of the gate width to between .2 to 4 microns. Reducing the gate width has obvious advantages in submicron processing technology such as increasing switching speeds and allowing for a higher packing density of transistors on the chip. To form raised souce/drain regions, a suitable metal layer, for example tungsten, is formed over the integrated circuit, preferably to a height greater than the polysilicon stacks which include the transistor 60 and interconnect 68. The metal layer is patterned and etched to form a metal region 86 overlying the transistor 60 and source and drain regions 77.

Referring to Figure 6, a portion of the metal layer 86 is etched away to form raised source/drain regions 88 overlying the source and drain regions 77 and exposing a portion of the capping layer 66 and sidewall oxide spacers 74. Removal of the metal layer may be by any acceptable method of planarization, for example, reactive ion etching selective to the metal chosen. The metal is preferably etched until the upper portion of the raised source/drain regions 88 is substantially the same height above the silicon substrate as the upper portion of the gate electrode 64. As with the selectively grown epitaxial raised source/drain regions described above, this will provide for a more planar device for subsequent processing steps. In addition, the metal raised source/drain regions will eliminate the need for siliciding the source/drain regions 77 in the substrate, thus reducing the possibility of junction leakage and punchthrough.

Referring to Figure 7, a second alternative embodiment is shown, again with similar reference numerals as those described above for similar regions. In this embodiment, the N⁺ or P⁺ heavily doped source and drain regions 77 are formed by conventional methods after the sidewall oxide spacers are formed and before the raised source/drain regions are formed. As with the first alternative embodiment described above with reference to Figure 7, the junction of the source/drain regions 77 will typically be deeper than the LDD regions 76. Regions of metal 90 are selectively deposited over the source/drain regions 77. The metal is preferably a refractory metal, for example, titanium or tungsten. Selective metal deposition may grow a thin layer of metal silicide over the source/drain regions 77 which may consume a portion of the substrate silicon. While any excessive amount of silicon consumption is not desired, this portion of the selective metal formation acts as a diffusion barrier as the remaining metal continues to be selectively grown over the source/drain regions. The metal regions may be deposited to a height substantially planar with the upper surface of the gate 64 of transistor 60, thus reducing the need for an etch back step. While there may be some faceting with selectively grown epitaxial regions, the selectively deposited metal will form a more planar upper surface. There needs to be a minimum thickness of the capping layer 66 and sidewall oxide spacers 74 to maintain adequate distance between the raised source and drain regions 90 from the gate electrode 64. This distance will insure the necessary electrical isolation of devices and maintain device integrity.

While the invention has been described herein relative to its preferred embodiments, it is of course contemplated that modifications of, and alternatives to, these embodiments, such modifications and alternatives obtaining the advantages and benefits of this invention, will be apparent to those of ordinary skill in the art having reference to this specification and its drawings. It is contemplated that such modifications and alternatives are within the scope of this invention as subsequently claimed herein.

## Claims

1. A method of forming a semiconductor integrated circuit, comprising the steps of:
forming a transistor (60) over a substrate (50) having a gate electrode layer (56) overlying a gate oxide layer (54), wherein the transistor (60) is electrically isolated by a plurality of field oxide regions (52),
forming a dielectric capping layer (58) on the gate electrode layer;
etching a gate electrode (64) from the gate oxide layer (54), gate electrode layer (56), and capping layer (58);
forming lightly doped (LDD) regions (76) in the substrate (50) adjacent to the gate electrode;
forming sidewall oxide spacers (74) adjacent to the transistor after the LDD regions (76) are formed; and
forming planarized raised source/drain regions (88, 90) adjacent to the sidewall oxide spacers (74) ; wherein the raised source/drain regions are metal and the step of forming a planarized raised metal source/drain regions (90) further comprises the steps of:
prior to forming the raised source/drain regions, forming more heavily doped substrate source and drain regions (77) in the substrate (50) after the sidewall oxide spacers (74) are formed; and then
forming metal regions (88,90) over the substrate source and drain regions and wherein said metal source/drain regions (88, 90) overly the substrate source/drain regions (77), leaving a portion of the capping layer and sidewall spacers exposed.

2. The method of claim 1, wherein the formation of the transistor comprises the steps of:
forming an oxide layer (54) over the integrated circuit; forming polysilicon (56) over the gate oxide; and
patterning and etching the polysilicon (56) and oxide layers (54) to form the gate electrode (64) and gate oxide (62), respectively.

3. The method of claim 2, wherein forming the capping layer (58) further comprises the step of:
forming a dielectric layer (58) to a thickness of 100-30 nm (1000-3000 angstroms) over the polysilicon layer (56) before the polysilicon is patterned and etched to form the transistor.

4. The method of any one of claims 1 to 3, wherein the step of forming a planarized raised metal source/drain region (88) comprises the steps of:
forming a metal layer (86) over the integrated circuit to a height greater than the capping layer (66);
patterning and etching the metal layer (86) to remain over the transistor and substrate source and drain regions; and
removing the metal layer (86) over the capping layer (66) and a portion of the sidewall oxide spacers (74).

5. The method of any one of claims 1 to 3, wherein the metal regions (90) are selectively deposited over the substrate source and drain regions.

6. The method of any preceding claim, wherein the height of an upper surface of the planarizing raised source/drain regions (88,90) above the substrate surface is approximately the same as the height of an upper surface of the gate electrode of the transistor above the substrate surface.

7. The method of any preceding claim, wherein the distance between the planarized raised metal source/drain regions (88,90) and the gate electrode (64) is large enough for adequate electrical isolation to prevent shorting between the raised source/drain regions and the gate electrode (64).

8. The method of forming a semiconductor integrated circuit, as claimed in claim 1, wherein the planarized raised metal source/drain regions are formed such that an upper surface of the raised source and drain regions are substantially planar with an upper surface of the gate electrode of the transistor, and
wherein the source/drain regions are electrically isolated from the gate electrode layer.

## Patentansprüche

1. Verfahren zum Bilden einer integrierten Halbleiterschaltung, welches die folgenden Schritte umfasst:
Bilden eines Transistors (60) über einem Substrat (50) mit einer eine Gate-Oxidschicht (54) überlagernden Gate-Elektrodenschicht (56), wobei der Transistor (60) durch eine Vielzahl von Feldoxidbereichen (52) elektrisch isoliert wird,
Bilden einer dielektrischen Deckschicht (58) auf der Cate-Elektrodenschicht;
Ätzen einer Gate-Elektrode (64) aus der Gate-Oxidschicht (54), der Gate-Elektrodenschicht (56) und der Deckschicht (58);
Bilden von leicht dotierten (LDD) Bereichen (76) in dem an die Gate-Elektrode angrenzenden Substrat (50);
Bilden von an den Transistor angrenzenden Seitenwand-Oxid-Abstandshaltern (74), nachdem die LDD-Bereiche (76) gebildet worden sind; und
Bilden von geebneten erhöhten Source/Drain-Bereichen (88, 90) angrenzend an die Seitenwand-Oxid-Abstandshalter (74), wobei die erhöhten Source/Drain-Bereiche aus Metall sind und der Schritt des Bildens von geebneten erhöhten Metall-Source/Drain-Bereichen (90) weiterhin die folgenden Schritte umfasst:
vor dem Bilden der erhöhten Source/Drain-Bereiche, Bilden von stärker dotierten Substrat-Source- und Drain-Bereichen (77) in dem Substrat (50), nachdem die Seitenwand-Oxid-Abstandshalter (74) gebildet worden sind; und sodann
Bilden von Metallbereichen (88, 90) über den Substrat-Source- und -Drain-Bereichen, und wobei die Metall-Source/Drain-Bereiche (88, 90) die Substrat-Source/Drain-Bereiche (77) überlagern, wobei sie einen Teil der Deckschicht und der Seitenwand-Abstandshalter frei lassen.

2. Verfahren nach Anspruch 1, bei welchem die Bildung des Transistors die folgenden Schritte umfasst:
Bilden einer Oxidschicht (54) über der integrierten Schaltung;
Bilden von Polysilizium (56) über dem Gate-Oxid; und
Strukturieren und Ätzen der Polysilizium- (56) und der Oxid-Schicht (54) zum Bilden der Gate-Elektrode bzw. des Gate-Oxids (62).

3. Verfahren nach Anspruch 2, bei welchem das Bilden der Deckschicht (58) weiterhin den folgenden Schritt umfasst:
Bilden einer dielektrischen Schicht (58) bis zu einer Dicke von 100-300 nm (1000-3000 Angström) über der Polysiliziumschicht (56), bevor das Polysilizium zum Bilden des Transistors strukturiert und geätzt wird.

4. Verfahren nach einem der Ansprüche 1 bis 3, bei welchem der Schritt des Bildens eines geebneten erhöhten Metall-Source/Drain-Bereichs (88) die folgenden Schritte umfasst:
Bilden einer Metallschicht (86) über der integrierten Schaltung bis zu einer Höhe, die größer als die Deckschicht (66) ist;
Strukturieren und Ätzen der Metallschicht (86) zum Verbleib über den Transistor- und Substrat-Source- und -Drain-Bereichen; und
Entfernen der Metallschicht (86) über der Deckschicht (66) und einem Teil der Seitenwand-Oxid-Abstandshalter (74).

5. Verfahren nach einem der Ansprüche 1 bis 3, bei welchem die Metallbereiche (90) wahlweise über den Substrat-Source- und -Drain-Bereichen abgelagert werden.

6. Verfahren nach einem der vorangehenden Ansprüche, bei welchem die Höhe einer oberen Oberfläche der geebneten, erhöhten Source/Drain-Bereiche (88, 90) über der Substratoberfläche ungefähr dieselbe ist wie die Höhe einer oberen Oberfläche der Gate-Elektrode des Transistors über der Substratoberfläche.

7. Verfahren nach einem der vorangehenden Ansprüche, bei welchem die Entfernung zwischen den geebneten, erhöhten Metall-Source/Drain-Bereichen (88, 90) und der Gate-Elektrode (64) groß genug ist für eine angemessene elektrische Isolierung zum Vermeiden eines Kurzschlusses zwischen den erhöhten Source/Drain-Bereichen (88, 90) und der Gate-Elektrode (64).

8. Verfahren zum Bilden einer integrierten Halbleiterschaltung, wie in Anspruch 1 beansprucht, bei welchem die geebneten erhöhten Metall-Source/Drain-Bereiche so gebildet werden, dass eine obere Oberfläche der erhöhten Source- und Drain-Bereiche im Wesentlichen eben sind mit einer oberen Oberfläche der Gate-Elektrode des Transistors,
und bei welchem die Source-/Drain-Bereiche elektrisch von der Gate-Elektrodenschicht isoliert werden.

## Revendications

1. Méthode pour former un circuit intégré à semiconducteurs comprenant les étapes de :
formation d'un transistor (60) par-dessus un substrat (50) possédant une couche d'électrode grille (56) superposée à une couche d'oxyde de grille (54), le transistor (60) étant isolé électriquement par une pluralité de régions d'oxyde de champ (52),
formation d'une couche de recouvrement diélectrique (58) sur la couche d'électrode grille ;
gravure d'une électrode grille (64) dans la couche d'oxyde de grille (54), la couche d'électrode grille (56) et la couche de recouvrement (58) ;
formation dans le substrat (50) de régions faiblement dopées (LDD) (76) adjacentes à l'électrode grille ;
formation de séparateurs latéraux en oxyde (74) adjacents au transistor après la formation des régions LDD (76) ; et
formation de régions de source/drain saillantes aplanies (88, 90) adjacentes aux séparateurs latéraux en oxyde (74),
les régions de source/drain étant métalliques et l'étape de formation de régions de source/drain saillantes aplanies (90) comprenant en outre les étapes suivantes :
avant la formation des régions de source/drain saillantes, formation dans le substrat (50) de régions de source et de drain de substrat plus fortement dopées (77) après la formation des séparateurs latéraux en oxyde (74) ;
formation de régions métalliques (88, 90) par-dessus les régions de source et de drain de substrat, lesdites régions de source/drain métalliques (88, 90) recouvrant les régions de source/drain de substrat (77) en laissant à nu une partie de la couche de recouvrement et des séparateurs latéraux.

2. Méthode selon la revendication 1, **caractérisée en ce que** la formation du transistor comprend les étapes de :
formation d'une couche d'oxyde (54) par-dessus le circuit intégré ;
formation de polysilicium (56) par-dessus l'oxyde de grille ; et
conformation et gravure des couches de polysilicium (56) et d'oxyde (54) pour former l'électrode grille (64) et l'oxyde de grille (62), respectivement.

3. Méthode selon la revendication 2, **caractérisée en ce que** la formation de la couche de recouvrement (58) comprend en outre l'étape de :
formation d'une couche diélectrique (58) ayant une épaisseur de 100-300 nm (1000-3000 angströms) par-dessus la couche de polysilicium (56) avant que le polysilicium soit conformé et gravé pour former le transistor.

4. Méthode selon l'une quelconque des revendications 1 à 3, **caractérisée en ce que** l'étape de formation d'une région de source/drain métallique saillante aplanie (88) comprend les étapes de :
formation d'une couche de métal (86) par-dessus le circuit intégré sur une hauteur supérieure à la couche de recouvrement (66) ;
conformation et gravure de la couche de métal (86) en maintenant celle-ci au-dessus du transistor et des régions de source et de drain du substrat ; et
élimination de la couche de métal (86) par-dessus la couche de recouvrement (66) et une partie des séparateurs latéraux en oxyde (74).

5. Méthode selon l'une quelconque des revendications 1 à 3, **caractérisée en ce que** les régions métalliques (90) sont déposées sélectivement par-dessus les régions de source et de drain du substrat.

6. Méthode selon l'une quelconque des revendications précédentes, **caractérisée en ce que** la hauteur d'une surface supérieure des régions de source/drain saillantes aplanies (88, 90) au-dessus de la surface du substrat est approximativement égale à la hauteur d'une surface supérieure de l'électrode grille du transistor au-dessus de la surface du substrat.

7. Méthode selon l'une quelconque des revendications précédentes, **caractérisée en ce que** la distance entre les régions de source/drain métalliques saillantes aplanies (88, 90) et l'électrode grille (64) est suffisante pour obtenir une isolation adéquate empêchant les courts-circuits entre les régions de source/drain saillantes et l'électrode grille (64).

8. Méthode de formation d'un circuit intégré à semiconducteurs selon la revendication 1, **caractérisée en ce que** les régions de source/drain métalliques saillantes aplanies sont formées de telle manière qu'une surface supérieure des régions de source et de drain saillantes soit sensiblement de niveau avec une surface supérieure de l'électrode grille du transistor, et
**en ce que** les régions de source/drain sont isolées électriquement de la couche d'électrode grille.
